# EUROPÄISCHE PATENTSCHRIFT

(11) **EP 2 640 593 B1**
(45) Veröffentlichungstag und Bekanntmachung des Hinweises auf die Patenterteilung: **01.04.2015**
(21) Anmeldenummer: 11769816.7
(22) Anmeldetag: 27.09.2011
(51) Int. Cl.: B60L 11/18, H02J 7/00, G01R 31/36

(54) **AUTONOMES BATTERIE-BALANCING**
AUTONOMOUS BATTERY BALANCING
ÉQUILIBRAGE DE BATTERIE AUTONOME

(30) Priorität: 16.11.2010 DE 102010043950
(43) Veröffentlichungstag der Anmeldung: 25.09.2013
(73) Patentinhaber: Robert Bosch GmbH, 70442 Stuttgart (DE); Samsung SDI Co., Ltd., Yongin-si Gyeonggi-do 446-577 (KR)
(72) Erfinder: BUTZMANN, Stefan, 71717 Beilstein (DE)
(74) Vertreter: Bee, Joachim
(86) Internationale Anmeldenummer: PCT/EP2011/066731
(87) Internationale Veröffentlichungsnummer: WO 2012/065779

(56) Entgegenhaltungen:
- US-A- 5 677 613
- US-A- 6 054 841
- US-A- 6 121 752
- US-A1- 2006 001 403

## Beschreibung

Die vorliegende Erfindung betrifft eine Vorrichtung zum Balancing (Ladungsausgleich) der Batteriezellen einer Batterie mit mehreren in Serie geschalteten Batteriezellen, wobei erfindungsgemäß keine Steuerung durch einen Mikrocontroller notwendig ist, die Vorrichtung also autonom operieren kann.

### Stand der Technik

Es zeichnet sich ab, dass in Zukunft sowohl bei stationären Anwendungen als auch bei Fahrzeugen wie Hybrid- und Elektrofahrzeugen vermehrt Batteriesysteme zum Einsatz kommen werden. Um die für eine jeweilige Anwendung gegebenen Anforderungen an Spannung und zur Verfügung stellbaren Leistung erfüllen zu können, werden eine hohe Zahl von Batteriezellen in Serie geschaltet. Der Ausfall einer Batteriezelle kann wegen der Serienschaltung zum Ausfall der Batterie und dieser wiederum zu einem Ausfall des Gesamtsystems führen, weshalb insbesondere für sicherheitsrelevante Anwendungen hohe Anforderungen an die Zuverlässigkeit der Batterie gestellt werden. Um den Zustand der Batterie und der einzelnen Batteriezellen möglichst genau erfassen und so einen drohenden Ausfall einer Batteriezelle rechtzeitig erkennen zu können, werden neben anderen Parametern der Batterie beziehungsweise Batteriezellen insbesondere auch die Spannungen der Batteriezellen regelmäßig gemessen. Im Stand der Technik sind zahlreiche Verfahren bekannt, die ein so genanntes Cell-Balancing durchführen, also die Ladungszustände der verschiedenen Batteriezellen einer Batterie einander anzugleichen suchen, was sich positiv auf die Lebensdauer der Batterie auswirkt. Die Batterie ist hierzu mit Einheiten ausgestattet, die die Zellspannungen der einzelnen Batteriezellen sowie optional weitere Messgrößen wie Batterietemperatur und Batteriestrom bestimmen und an eine zentrale Steuereinheit (beispielsweise ein Mikrocontroller) übermitteln. Die Steuereinheit berechnet aus den übermittelten Messdaten für jede Batteriezelle einen jeweiligen Ladungszustand und erzeugt die für die Durchführung des Cell-Balancings notwendigen Steuersignale, welche in der Batterie den Ladungsausgleich unter den Batteriezellen bewirken, indem beispielsweise Batteriezellen mit einem höheren Ladungszustand teilweise entladen werden. Dabei wird die Steuereinheit außerhalb der Batterie angeordnet, um weitere Aufgaben übernehmen zu können. Dies bringt jedoch den Nachteil mit sich, dass relativ aufwendige Sicherheitsmaßnahmen wie im Datenpfad angeordnete Isolatoren ergriffen werden müssen, um im Fehlerfall einen Kurzschluss zwischen der hohen Batteriespannung (bei batteriebetriebenen Antriebssystemen oft mehrere hundert Volt) und den von außen berührbaren, im Niederspannungsnetz angeordneten Teilen wie der Steuereinheit zu verhindern.

Die US2006/001403A1 offenbart eine Spannungsdetektionsvorrichtung für eine Batterie mit einer Vielzahl von in Reihe miteinander verbundenen Batterieblöcken. In der Spannungserfassungsvorrichtung wird in jedem der Batterieblöcke ein Signaldetektor vorgesehen. Jeder der Signaldetektoren detektiert eine Spannung in jedem Batterieblock auf und erzeugt ein Detektionssignal, das Informationen über die detektierte Spannung umfasst, wenn eine abnorme Spannung vorliegt.

Die US5677613A offenbart ein Verfahren zur Regelung des von einem Ladegerät zu den Endanschlüssen eines Systems vom Typ eines elektrischen Akkumulators, der aus einer Vielzahl von Zellen besteht und durch ihre jeweiligen Versorgungsanschlüsse in Reihe verbunden sind, gelieferten Stroms, wobei jede Zelle mit einer individuellen Schnittstelle versehen ist, die Mittel zum Messen der zwischen ihren Versorgungsanschlüssen vorhandene Spannung, Mittel zum Abzweigen eines Teils des zu dieser Zelle gelieferten Ladestroms, wenn die gemessene Spannung über einem Schwellenwert liegt, sowie Mittel zum Liefern von Meßsignalen an eine Steuereinheit des Ladegeräts aufweist.

### Offenbarung der Erfindung

Erfindungsgemäß wird daher eine Vorrichtung zum Cell-Balancing der Batteriezellen einer Batterie mit mehreren in Serie geschalteten Batteriezellen eingeführt. Die Vorrichtung umfasst eine mit jeder der Batteriezellen verbundene oder verbindbare Messvorrichtung, welche ausgebildet ist, einen zu einer minimalen Zellspannung aller Zellspannungen der Batteriezellen proportionalen Strom zu erzeugen und an eine Mehrzahl von in Serie geschalteten Widerständen auszugeben. Eine Anzahl n der Widerstände ist dabei gleich einer Anzahl von mit der Messvorrichtung verbundenen oder verbindbaren Batteriezellen. Die Vorrichtung besitzt außerdem eine Anzahl n-1 Potentialreplikationseinrichtungen, welche jeweils zwischen zwei benachbarte Widerstände der Mehrzahl von Widerständen geschaltet und ausgebildet sind, ein Potential an einem ersten Pol einer zugeordneten Batteriezelle zu replizieren und an einen ersten der jeweiligen zwei benachbarten Widerstände auszugeben. Die Vorrichtung enthält außerdem eine Anzahl n Vergleicher, welche jeweils einen mit einem zweiten Pol einer zugeordneten Batteriezelle verbundenen ersten Eingang, einen mit einem zweiten der jeweiligen benachbarten Widerstände verbundenen zweiten Eingang und einen mit einer Steuerelektrode einer jeweiligen Entladeeinheit verbundenen Ausgang aufweisen. Die Vergleicher sind ausgebildet, eine am ersten Eingang anliegende erste Spannung mit einer am zweiten Eingang anliegenden zweiten Spannung zu vergleichen und ein von einem Ergebnis des Vergleichs abhängiges Steuersignal auszugeben. Dabei sind die Entladeeinheiten zu einer jeweiligen Batteriezelle parallel geschaltet und ausgebildet, abhängig von dem Steuersignal einen Entladestrom aus der jeweiligen Batteriezelle fließen zu lassen.

Die Erfindung hat den Vorteil, dass ein Cell-Balancing der Batteriezellen der Batterie vollständig autark vorgenommen werden kann, also eine Steuerung durch eine außerhalb der Batterie angeordnete Steuereinheit entfallen kann. Dazu ist lediglich eine einfache elektronische Schaltung notwendig, welche eine minimale Zellspannung aller Batteriezellen bestimmt und die Zellspannungen der einzelnen Batteriezellen mit dieser minimalen Zellspannung vergleicht. Ist die Zellspannung einer gegebenen Batteriezelle höher als die minimale Zellspannung, wird die Batteriezelle durch die zugeordnete Entladeeinheit entladen.

Erfindungsgemäß können auf diese Weise aufwendige Maßnahmen zur Isolation der Batterie gegenüber dem Niederspannungsnetz, in dem eine solche Steuereinheit gewöhnlich angeordnet wird, entfallen.

Bevorzugt enthalten die Entladeeinheiten eine schaltbare Stromquelle, welche ausgebildet ist, auf einen ersten logischen Pegel des Steuersignals den Entladestrom fließen zu lassen und auf einen zweiten logischen Pegel des Steuersignals einen Stromfluss zu unterbinden. Die schaltbare Stromquelle kann in einer einfachen und daher bevorzugten Ausführung einen Strombegrenzungswiderstand und einen Schalter enthalten, wobei eine Steuerelektrode des Schalters die Steuerelektrode der Entladeeinheit bildet. Der Entladestrom wird bei dieser Ausführungsform zudem proportional zu der Zellspannung der zu entladenden Batteriezelle, so dass vorteilhaft bereits relativ stark entladene Batteriezellen im Rahmen des Cell-Balancings weniger stark entladen werden als Batteriezellen mit höheren Ladungszuständen.

Die Vergleicher sind bevorzugt ausgebildet, das Steuersignal mit dem ersten logischen Pegel auszugeben, wenn eine Zellspannung der zugeordneten Batteriezelle größer ist als die minimale Zellspannung aller Zellspannungen der Batteriezellen zuzüglich einer Offsetspannung. Dadurch können dynamische Effekte wie kurzfristig schwankende Zellspannungen oder Rauschen, die zu einem störenden fortlaufenden schnellen Umschalten der Entladeeinheiten führen können, unterdrückt werden.

Die Potentialreplikationseinrichtungen können jeweils einen pnp-Transistor und einen npn-Transistor umfassen, wobei eine Basis des pnp-Transistors mit dem ersten Pol der zugeordneten Batteriezelle, ein Emitter des pnp-Transistors mit einer Basis des npn-Transistors und ein Emitter des npn-Transistors mit dem ersten der jeweiligen zwei benachbarten Widerstände verbunden sind. Diese Ausführungsform der Potentialreplikationseinrichtungen hat den Vorteil, dass das Potential an der Basis des pnp-Transistors sehr genau am Emitter des npn-Transistors nachgebildet wird, weil sich die Basis-Emitter-Spannungen der beiden Transistoren gegenseitig wegheben. Dabei ist außerdem vorteilhaft, dass das Temperaturverhalten der Basis-Emitter-Spannungen der beiden Transistoren über weite Temperaturbereiche gleich oder mindestens sehr ähnlich ist, so dass die gegenseitige Kompensation der Basis-Emitter-Spannungen temperaturunabhängig funktioniert.

Die Mehrzahl der seriengeschalteten Widerstände weist jeweils einen Widerstandswert auf, der einem Quotienten der minimalen Zellspannung aller Zellspannungen der Batteriezellen und des zu der minimalen Zellspannung aller Zellspannungen der Batteriezellen proportionalen Stromes entspricht.

Die Messvorrichtung kann eine Anzahl n von Differenzverstärkern aufweisen, wobei jeder der Differenzverstärker ein Paar von Transistoren umfasst, deren Emitter oder Source miteinander und mit einen Eingang für eine Stromquelle und deren Steuerelektroden mit einem jeweiligen von zwei Signaleingängen des Differenzverstärkers verbunden sind. Dabei sind bevorzugt der Eingang für die Stromquelle eines ersten der Differenzverstärker mit einer Stromquelle und der Kollektor oder der Drain eines der Transistoren des Paares von Transistoren mit dem Eingang für die Stromquelle eines weiteren der Differenzverstärker verbunden, so dass sich eine Kaskadierung der Differenzverstärker ergibt. Diese Kaskadierung von Differenzverstärkern besitzt den Vorteil, dass jeder der Differenzverstärker als Stromquelle für den darüber angeordneten Differenzverstärker wirkt. Aufgrund der Funktionsweise eines Differenzverstärkers mit zwei Zweigen fließt der Strom jedoch jeweils nur in einem Zweig des Differenzverstärkers, abhängig von den an den Eingängen des Differenzverstärkers anliegenden Spannungen. Daher kann ein Strom durch alle Differenzverstärker und somit durch die Messvorrichtung nur fließen, wenn die Spannung an beiden Eingängen gleich oder die Spannung über der jeweiligen Batteriezelle größer als die Spannung über den am anderen Eingang des jeweiligen Differenzverstärkers angeschlossenen Widerstandes ist. Dadurch ergibt sich ein Regelsystem, dass den Strom am Ausgang der Messvorrichtung genau so einstellt, dass er proportional zu der minimalen Zellspannung aller Zellspannungen wird.

Ein zweiter Aspekt der Erfindung führt eine Batterie mit einer Mehrzahl von in Reihe geschalteten Batteriezellen, vorzugsweise Lithium-Ionen-Batteriezellen, und einer mit den Batteriezellen verbundenen Vorrichtung gemäß dem ersten Erfindungsaspekt ein.

Ein dritter Erfindungsaspekt betrifft ein Kraftfahrzeug mit einem elektrischen Antriebsmotor zum Antreiben des Kraftfahrzeuges und einer mit dem elektrischen Antriebsmotor verbundenen Batterie gemäß dem vorhergehenden Erfindungsaspekt.

### Zeichnungen

Ausführungsbeispiele der Erfindung werden anhand der Zeichnungen und der nachfolgenden Beschreibung näher erläutert, wobei gleiche Bezugszeichen gleiche oder funktional gleichartige Komponenten bezeichnen. Es zeigen:
Figur 1 ein erstes Ausführungsbeispiel einer Messvorrichtung zum Einsatz im Rahmen der Erfindung,
Figur 2 ein zweites Ausführungsbeispiel einer Messvorrichtung zum Einsatz im Rahmen der Erfindung,
Figur 3 ein drittes Ausführungsbeispiel einer Messvorrichtung zum Einsatz im Rahmen der Erfindung,
Figur 4 ein erstes Ausführungsbeispiel eines erfindungsgemäßen Vergleichers und einer Entladeeinheit zum Einsatz im Rahmen der Erfindung, und
Figur 5 ein zweites Ausführungsbeispiel eines erfindungsgemäßen Vergleichers und einer Entladeeinheit zum Einsatz im Rahmen der Erfindung.

### Ausführungsformen der Erfindung

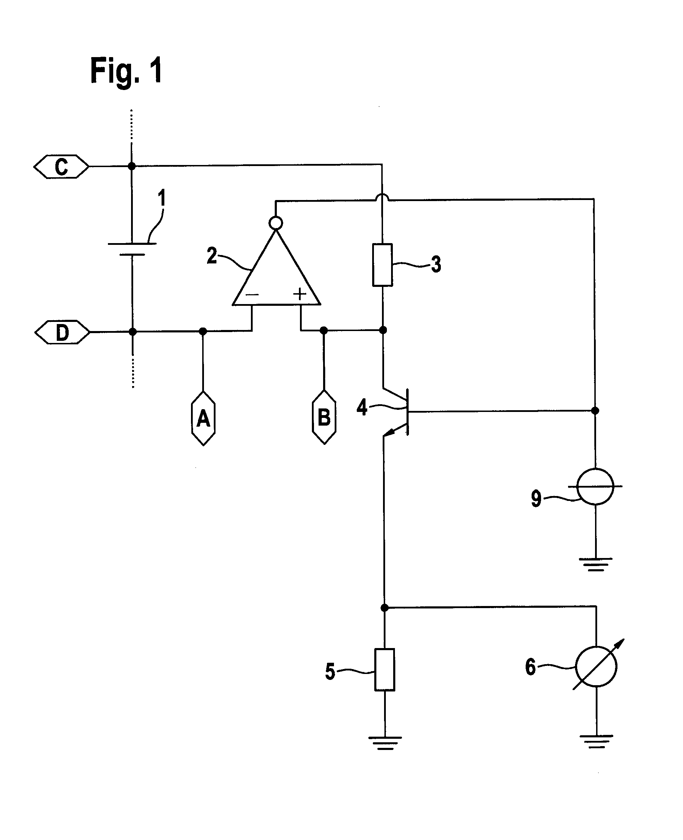

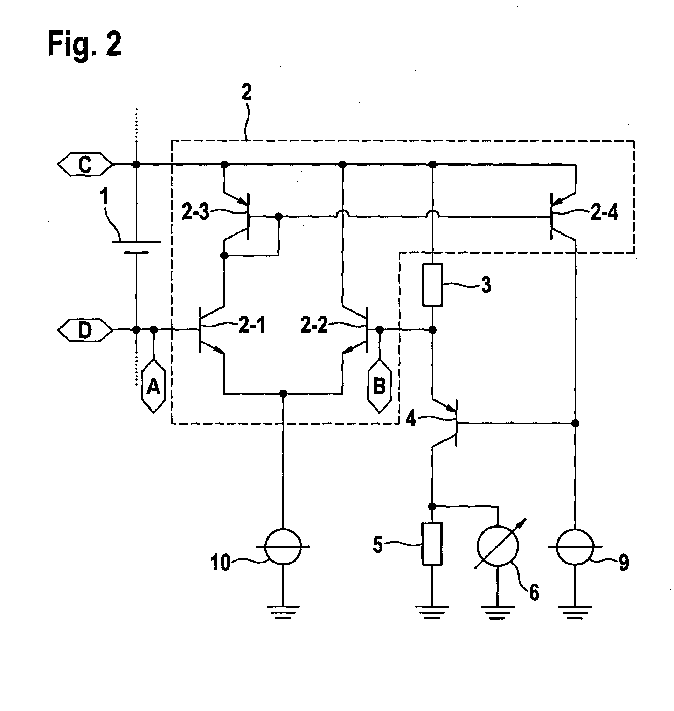

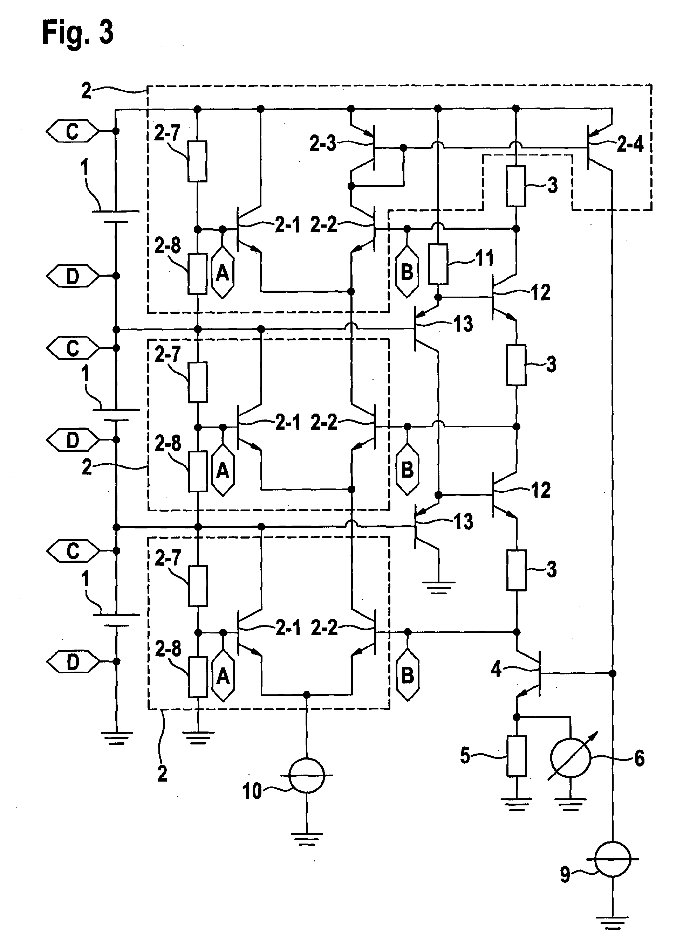

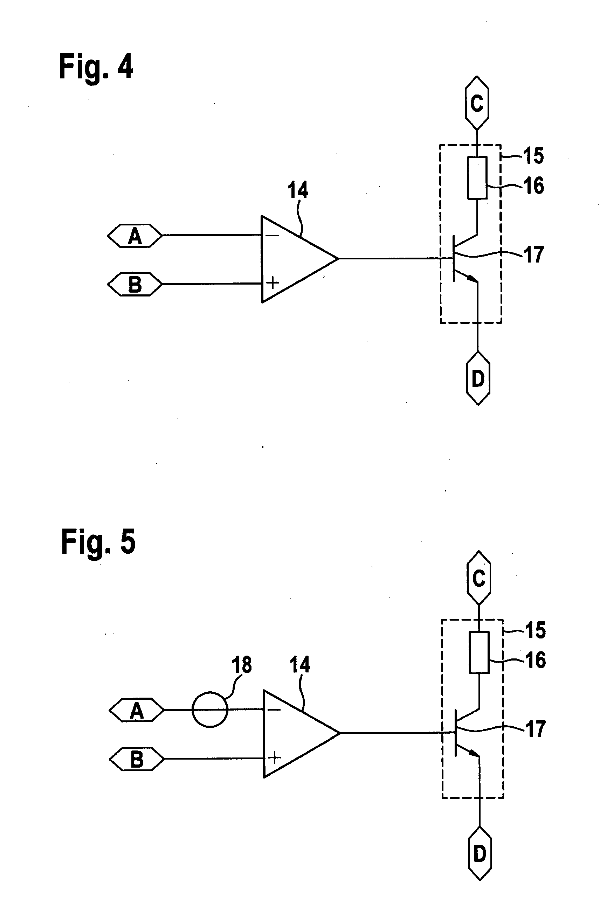

Figur 1 zeigt ein erstes Ausführungsbeispiel einer Messvorrichtung zum Einsatz im Rahmen der Erfindung. Die Figuren 1 und 2 dienen zur Erläuterung der Funktionsweise einer Messvorrichtung zum Einsatz im Rahmen der Erfindung. Figur 3 zeigt eine mögliche Implementation einer Messvorrichtung zur Verwendung mit einer Mehrzahl von Batteriezellen. In den Figuren 1 bis 3 sind Anschlusspunkte A, B, C und D markiert, an welche erfindungsgemäß weitere Schaltungselemente anzuschließen sind, die in den Figuren 4 und 5 gezeigt werden. In den Figuren 4 und 5 sind die den Anschlusspunkten A, B, C und D jeweils zuzuordnenden Anschlüsse durch Verwendung identischer Kennzeichnungen bezeichnet.

Ein erster Pol einer Batteriezelle 1, welche mit weiteren Batteriezellen zu einem Strang in Reihe geschaltet ist, ist mit einem von zwei Eingängen eines Transimpedanzverstärkers 2 verbunden. Der zweite Eingang des Transimpedanzverstärkers 2 ist mit einem Anschluss eines Widerstandes 3 verbunden, dessen weiterer Anschluss wiederum mit einem verbleibenden Pol der Batteriezelle 1 verbunden ist. Der Ausgang des Transimpedanzverstärkers 2 ist mit einer Steuerelektrode eines Stromventils 4 verbunden, welches im gezeigten Beispiel als npn-Transistor ausgeführt ist. Es können jedoch auch andere Transistortypen oder auch komplexere Schaltungen als Stromventil 4 zum Einsatz kommen. Das Stromventil 4 ist zwischen den mit dem Transimpedanzverstärker 2 verbundenen Anschluss des Widerstandes 3 und die eigentliche Spannungsmessvorrichtung, die in allen Ausführungsbeispielen nur beispielhaft gezeigt ist, geschaltet. Diese Spannungsmessvorrichtung kann einen Referenzwiderstand 5 mit einem bekannten Widerstandswert und ein Voltmeter 6 umfassen, welches die über dem Referenzwiderstand 5 abfallende Spannung misst.

Der Transimpedanzverstärker 2 vergleicht die Zellspannung der Batteriezelle 1 mit der über dem Widerstand 3 abfallenden Spannung und erzeugt einen Ausgangsstrom, dessen Größe proportional zur Differenz der beiden Spannungen ist. Dieser Ausgangsstrom gelangt an die Steuerelektrode des Stromventils 4, an welche eine optionale Sollstromquelle 9 angeschlossen sein kann. Diese Sollstromquelle 9 führt einen konstanten Strom und dient zur Arbeitspunkteinstellung des Stromventils 4. Der Ausgangsstrom des Transimpedanzverstärkers 2 - gegebenenfalls abzüglich des konstanten Stromes der Sollstromquelle 9 - steuert den Strom, den das Stromventil 4 passieren lässt. Je mehr Strom das Stromventil 4 passieren lässt, desto größer wird jedoch auch die Spannung, die über dem Widerstand 3 abfällt. Dies führt dazu, dass die Spannung an einem Eingang des Transimpedanzverstärkers 2 relativ zu der Spannung an dessen anderen Eingang ansteigt, wodurch die Differenz der Eingangsspannungen abnimmt und der Transimpedanzverstärker 2 auch seinen Ausgangsstrom entsprechend verringert. Fließt jedoch zu wenig Strom über den Widerstand 3, wird der Transimpedanzverstärker 2 entsprechend wieder mehr Strom an die Steuerelektrode des Stromventils 4 fließen lassen.

Es ergibt sich dadurch eine Rückkopplung, die dazu führt, dass die Spannung über dem Widerstand 3 aufgrund der Regelwirkung der den Transimpedanzverstärker 2, den Widerstand 3 und das Stromventil 4 umfassenden Regelzelle gleich der Zellspannung gehalten wird. Da die Eingänge des Transimpedanzverstärkers 2 idealerweise hochohmig ausgeführt sind, fließt der gesamte Strom, der durch den Widerstand 3 fließt, auch durch das Stromventil 4 und stellt aufgrund des linearen Zusammenhangs zwischen Spannung, Widerstand und Strom ein exaktes Maß für die Zellspannung dar. Er könnte nun an anderer Stelle gemessen werden, wenn Interesse an seinem tatsächlichen Wert besteht, beispielsweise indem er über einen selbst nicht zur Messvorrichtung gehörenden Referenzwiderstand 5 geleitet wird und dadurch in eine Spannung umgewandelt wird, deren Höhe sich direkt aus der Zellspannung ergibt und an ihrer Stelle unabhängig von den gewöhnlich hohen und variablen Potentialen an den Batteriepolen der Batteriezelle 1 und damit gefahrlos gemessen werden kann. Hierbei ist gegebenenfalls noch ein Korrekturfaktor zu berücksichtigen, der das Verhältnis des Betrages des Widerstands 3 zu dem des Referenzwiderstandes 5 angibt. Um eine Verfälschung des vom Stromventil 4 ausgegebenen Stromes durch den Basisstrom des im gezeigten Beispiel als Bipolartransistor ausgeführten Stromventils 4 zu vermeiden, können beispielsweise ein MOSFET oder ein IGBT (Insulated Gate Bipolar Transistor) verwendet werden.

Figur 2 zeigt ein zweites Ausführungsbeispiel einer Messvorrichtung zum Einsatz im Rahmen der Erfindung, bei dem der Transimpedanzverstärker 2 als Differenzverstärker ausgeführt ist. Der Transimpedanzverstärker 2 besitzt einen Anschluss für eine Stromquelle 10, welche einen Strom in den Differenzverstärker einprägt. Abhängig davon, welcher der beiden Transistoren 2-1 und 2-2 der beiden Zweige des Differenzverstärkers die größere Eingangsspannung erhält, wird der Strom der Stromquelle 10 entweder durch den einen Transistor oder den anderen fließen. Der durch den Transistor 2-1 fließende Strom wird über einen Stromspiegel, der die Transistoren 2-3 und 2-4 umfasst, gespiegelt und ausgegeben. Da die Funktionsweise eines Differenzverstärkers im Stand der Technik wohlbekannt ist, wird hier nicht weiter darauf eingegangen. Im Unterschied zu dem Ausführungsbeispiel von Figur 1 ist das Stromventil 4 als pnp-Transistor ausgeführt, wodurch ein geringerer Ausgangsstrom des Transimpedanzverstärkers 2, ausgegeben durch den Transistor 2-4, zu einem Abfall der Spannung an der Steuerelektrode des Stromventils 4 und dadurch zu einer Erhöhung der Basis-Emitter-Spannung des als pnp-Transistor ausgeführten Stromventils führt. Die erhöhte Basis-Emitter-Spannung bewirkt wiederum einen Anstieg des Stromes durch das Stromventil 4, was im Ergebnis wieder zu der erwünschten Rückkopplung führt.

Das Stromventil 4 könnte aber auch als npn-Transistor ausgeführt sein. In diesem Falle könnte der Transistor 2-3 einfach in den anderen Zweig des Differenzverstärkers geschaltet werden (zwischen den Pluspol der Batteriezelle 1 und den Transistor 2-2).

Die Stromquelle 9 führt vorzugsweise einen Strom, der der Hälfte des Stromes der Stromquelle 10 entspricht. Im eingeschwungenen Zustand der Regelzelle wird sich der Strom der Stromquelle 10 idealerweise zu gleichen Teilen auf die beiden Zweige des Differenzverstärkers aufteilen. In diesem Fall wird auch der Transistor 2-4 einen Strom ausgeben, der der Hälfte des Stromes der Stromquelle 10 entspricht, so dass die Spannung an der Steuerelektrode des Stromventils 4 konstant bleibt. Anstelle der Stromquelle 9 könnten jedoch beispielsweise auch ein einfacher Widerstand oder andere geeignete Schaltmittel zum Einsatz kommen.

Figur 3 zeigt ein drittes Ausführungsbeispiel einer Messvorrichtung zum Einsatz im Rahmen der Erfindung. Bei diesem Ausführungsbeispiel werden mehrere Regelzellen aufgebaut und kaskadiert. Die Transimpedanzverstärker 2 sind wiederum als Differenzverstärker aufgebaut, wobei jedoch der durch einen Zweig eines jeweiligen Differenzverstärkers fließende Strom als Stromquelle für den übergeordneten Differenzverstärker dient. Nur der unterste Differenzverstärker ist mit einer Stromquelle 10 verbunden, welche beispielsweise gemeinsam mit der Stromquelle 9 als Stromspiegel aufgebaut sein kann. Allerdings sind selbstredend auch andere Realisationsformen der Stromquellen 9 und 10 möglich.

Außer den Transimpedanzverstärkern 2 sind auch die Widerstände 3 kaskadiert. Da die Kaskade von Transimpedanzverstärkern aber nur einen einzigen Ausgangsstrom ausgibt, ist weiterhin nur ein Stromventil 4 vorgesehen, das als Transistor oder in einer anderen der gezeigten Arten realisiert sein kann.

Um das Potential oberhalb jedes der Widerstände 3 an dasjenige des Pluspols der jeweils zugeordneten Batteriezelle 1 anzugleichen, ohne den Stromfluss durch die Widerstände 3 zu beeinflussen, wird außerdem bei den unteren Regelzellen eine Potentialreplikationseinrichtung vorgesehen, die beispielsweise ein Paar von komplementären Transistoren 12 und 13 umfassen kann. Um dabei den Strom durch die kaskadierten Transistoren 13 zu begrenzen, wird außerdem vorzugsweise ein Widerstand 11 vorgesehen. Anstelle der Transistoren 12 und 13 sowie des Widerstandes 11 können jedoch auch andere Schaltungen vorgesehen werden, die das Potential an den Widerständen 3 demjenigen an den Pluspolen der Batteriezellen 1 angleichen.

Der mit den Batteriezellen 1 verbundene Eingang der Differenzverstärker kann einen aus Widerständen 2-7 und 2-8 gebildeten Spannungsteiler aufweisen, da andernfalls für den obersten Differenzverstärker kein ausreichend hohes Potential an den Kollektoren beziehungsweise für den untersten Differenzverstärker an den Emittern der Transistoren 2-1 und 2-2 mehr zur Verfügung stünde.

Die Messvorrichtung von Figur 3 besitzt die besondere Eigenschaft, dass die Zellspannungen von mehreren Batteriezellen 1 gleichzeitig gemessen werden können, wobei jedoch nur die minimale Zellspannung aller Batteriezellen 1 gemessen wird. Das heißt, dass der von der Kaskade der Differenzverstärker ausgegebene Strom bei dem Ausführungsbeispiel der Figur 3 proportional zu der kleinsten aller Zellspannungen ist. Die Messvorrichtung der Figur 3 kann dabei selbstredend auch für nur zwei Batteriezellen 1 oder eine größere Zahl von Batteriezellen ausgeführt werden.

Erfindungsgemäß wird die minimale Zellspannung aller Batteriezellen 1 bestimmt, um die Zellspannungen der weiteren Batteriezellen mit der minimalen Zellspannung vergleichen und bei einer hinreichend großen Abweichung die Zellspannungen der weiteren Batteriezellen gezielt reduzieren zu können. Durch dieses Cell-Balancing werden die Ladungszustände aller Batteriezellen einander angeglichen, was sich positiv auf die Lebensdauer der Batterie auswirkt. Indem die Erfindung ein einfaches Mittel zur Bestimmung der minimalen Zellspannung sowie Mittel zum Vergleichen der Spannung und zum Entladen der Batteriezellen zur Verfügung stellt, kann eine Vorrichtung zum Cell-Balancing realisiert werden, welche vollständig autark innerhalb der Batterie und ohne Einbeziehung von aufwendigen Komponenten wie Mikrocontrollern und dergleichen arbeiten kann.

Figur 4 zeigt ein erstes Ausführungsbeispiel eines erfindungsgemäßen Vergleichers und einer Entladeeinheit zum Einsatz im Rahmen der Erfindung. Der Vergleicher 14 ist bevorzugt als gewöhnlicher Differenzverstärker ausgeführt, der eine Ausgangsspannung erzeugt, die proportional zu einer zwischen seinen beiden Eingängen bestehenden Spannungsdifferenz ist. Aufgrund der hohen Verstärkung des Differenzverstärkers führen bereits geringe Spannungsdifferenzen zu einer Sättigung der Ausgangsspannung des Differenzverstärkers, so dass diese Ausgangsspannung als binäres Steuersignal angesehen werden kann. Dieses Steuersignal wird an einen Steuereingang einer Entladeeinheit 15 ausgegeben, welche abhängig vom logischen Pegel des Steuersignals eine mit der Entladeeinheit 15 verbundene Batteriezelle entlädt oder aber einen Stromfluss zwischen den Anschlusspunkten C und D durch die Entladeeinheit 15 hindurch unterbindet. Die Entladeeinheit 15 umfasst bevorzugt einen Schalttransistor 17, welcher beispielsweise als Bipolartransistor oder als Feldeffekttransistor ausgeführt sein kann. Der Schalttransistor 17 wird in diesem Fall direkt durch das von dem Vergleicher 14 erzeugte Steuersignal geschaltet. Um den Stromfluss durch die Entladeeinheit 15 im Fall des Entladens der Batteriezelle zu begrenzen, ist bevorzugt ein Begrenzungswiderstand 16 vorgesehen.

Figur 5 zeigt ein zweites Ausführungsbeispiel eines erfindungsgemäßen Vergleichers und einer Entladeeinheit zum Einsatz im Rahmen der Erfindung. Das zweite Ausführungsbeispiel unterscheidet sich vom ersten Ausführungsbeispiel dadurch, dass einer der Eingänge des Vergleichers 14 über eine Spannungsquelle 18 mit dem zugeordneten Anschlusspunkt verbunden ist. Die Spannungsquelle 18 erzeugt eine Differenzspannung, welche die Spannung an dem Eingang des Vergleichers 14 verändert. Dadurch wird der Vergleicher 14 den logischen Pegel des Steuersignals unter Berücksichtigung der Offsetspannung erzeugen. Dies bewirkt, dass eine mit dem Vergleicher 14 und der Entladeeinheit 15 verbundene Batteriezelle erst dann entladen wird, wenn die Zellspannung der Batteriezelle um mindestens die Offsetspannung größer als die minimale Zellspannung ist, wodurch fehlerhaftes Entladen durch Störeffekte wie Rauschen, Lastsprünge oder sonstige dynamische Einflüsse vermieden werden kann.

## Patentansprüche

1. Eine Vorrichtung zum Cell-Balancing der Batteriezellen (1) einer Batterie mit mehreren in Serie geschalteten Batteriezellen (1), die Vorrichtung umfassend eine mit jeder der Batteriezellen (1) verbundene oder verbindbare Messvorrichtung, welche ausgebildet ist, einen zu einer minimalen Zellspannung aller Zellspannungen der Batteriezellen (1) proportionalen Strom zu erzeugen und an eine Mehrzahl von in Serie geschalteten Widerständen (3) auszugeben, wobei eine Anzahl n der Widerstände (3) gleich einer Anzahl von mit der Messvorrichtung verbundenen oder verbindbaren Batteriezellen (1) ist, und einer Anzahl (n-1) Potentialreplikationseinrichtungen (12, 13), welche jeweils zwischen zwei benachbarte Widerstände (3) der Mehrzahl von Widerständen (3) geschaltet und ausgebildet sind, ein Potential an einem ersten Pol einer zugeordneten Batteriezelle (1) zu replizieren und an einen ersten der jeweiligen zwei benachbarten Widerstände (3) auszugeben, gekennzeichnet durch eine Anzahl n Vergleicher (14), welche jeweils einen mit einem zweiten Pol einer zugeordneten Batteriezelle (1) verbundenen ersten Eingang, einen mit einem zweiten der jeweiligen benachbarten Widerstände (3) verbundenen zweiten Eingang und einen mit einer Steuerelektrode einer jeweiligen Entladeeinheit (15) verbundenen Ausgang aufweisen und ausgebildet sind, eine am ersten Eingang anliegende erste Spannung mit einer am zweiten Eingang anliegenden zweiten Spannung zu vergleichen und ein von einem Ergebnis des Vergleichs abhängiges Steuersignal auszugeben, wobei die Entladeeinheiten (15) zu einer jeweiligen Batteriezelle (1) parallel geschaltet und ausgebildet sind, abhängig von dem Steuersignal einen Entladestrom aus der jeweiligen Batteriezelle (1) fließen zu lassen.

2. Die Vorrichtung gemäß Anspruch 1, bei der die Entladeeinheiten (15) eine schaltbare Stromquelle enthalten, welche ausgebildet ist, auf einen ersten logischen Pegel des Steuersignals den Entladestrom fließen zu lassen und auf einen zweiten logischen Pegel des Steuersignals einen Stromfluss zu unterbinden.

3. Die Vorrichtung gemäß Anspruch 2, bei der die schaltbare Stromquelle einen Strombegrenzungswiderstand (16) und einen Schalter (17) enthält, wobei eine Steuerelektrode des Schalters (17) die Steuerelektrode der Entladeeinheit (15) bildet.

4. Die Vorrichtung gemäß einem der Ansprüche 2 oder 3, bei der die Vergleicher (14) ausgebildet sind, das Steuersignal mit dem ersten logischen Pegel auszugeben, wenn eine Zellspannung der zugeordneten Batteriezelle (1) größer ist als die minimale Zellspannung aller Zellspannungen der Batteriezellen (1) zuzüglich einer Offsetspannung.

5. Die Vorrichtung gemäß einem der vorhergehenden Ansprüche, bei der die Potentialreplikationseinrichtungen jeweils einen pnp-Transistor (13) und einen npn-Transistor (12) umfassen, wobei eine Basis des pnp-Transistors (13) mit dem ersten Pol der zugeordneten Batteriezelle (1), ein Emitter des pnp-Transistors (13) mit einer Basis des npn-Transistors (12) und ein Emitter des npn-Transistors (12) mit dem ersten der jeweiligen zwei benachbarten Widerstände (3) verbunden sind.

6. Die Vorrichtung gemäß einem der vorhergehenden Ansprüche, bei der die Mehrzahl der seriengeschalteten Widerstände (3) jeweils einen Widerstandswert aufweist, der einem Quotienten der minimalen Zellspannung aller Zellspannungen der Batteriezellen (1) und des zu der minimalen Zellspannung aller Zellspannungen der Batteriezellen (1) proportionalen Stromes entspricht.

7. Die Vorrichtung gemäß einem der vorhergehenden Ansprüche, bei der die Messvorrichtung eine Anzahl n von Differenzverstärkern aufweist, wobei jeder der Differenzverstärker ein Paar von Transistoren (2-1, 2-2) umfasst, deren Emitter oder Source miteinander und mit einen Eingang für eine Stromquelle (10) und deren Steuerelektroden mit einem jeweiligen von zwei Signaleingängen des Differenzverstärkers verbunden sind.

8. Die Vorrichtung gemäß Anspruch 7, bei der der Eingang für die Stromquelle (10) eines ersten der Differenzverstärker mit einer Stromquelle (10) und der Kollektor oder der Drain eines der Transistoren (2-2) des Paares von Transistoren (2-1, 2-2) mit dem Eingang für die Stromquelle (10) eines weiteren der Differenzverstärker verbunden sind, so dass sich eine Kaskadierung der Differenzverstärker ergibt.

9. Eine Batterie mit einer Mehrzahl von in Reihe geschalteten Batteriezellen (1) und einer mit den Batteriezellen (1) verbundenen Vorrichtung gemäß einem der vorhergehenden Ansprüche.

10. Ein Kraftfahrzeug mit einem elektrischen Antriebsmotor zum Antreiben des Kraftfahrzeuges und einer mit dem elektrischen Antriebsmotor verbundenen Batterie gemäß dem vorhergehenden Anspruch.

## Claims

1. Apparatus for the cell balancing of the battery cells (1) of a battery having a plurality of battery cells (1) connected in series, the apparatus comprising a measuring apparatus, which is connected or can be connected to each of the battery cells (1) and which is designed to generate a current proportional to a minimum cell voltage of all the cell voltages of the battery cells (1) and to output said current to a plurality of resistors (3) connected in series, wherein a number n of the resistors (3) is equal to a number of battery cells (1) which are connected or can be connected to the measuring apparatus, and a number (n-1) of potential replication devices (12, 13), which are in each case connected between two adjacent resistors (3) of the plurality of resistors (3) and are designed to replicate a potential at a first pole of an assigned battery cell (1) and to output it to a first of the respective two adjacent resistors (3), **characterized by** a number n of comparators (14), which each have a first input connected to a second pole of an assigned battery cell (1), a second input connected to a second of the respective adjacent resistors (3), and an output connected to a control electrode of a respective discharging unit (15) and are designed to compare a first voltage present at the first input with a second voltage present at the second input and to output a control signal dependent on a result of the comparison, wherein the discharging units (15) are connected in parallel with a respective battery cell (1) and are designed to allow a discharge current to flow from the respective battery cell (1) depending on the control signal.

2. Apparatus according to Claim 1, wherein the discharging units (15) contain a switchable current source, which is designed to allow the discharge current to flow in response to a first logic level of the control signal and to prevent a current flow in response to a second logic level of the control signal.

3. Apparatus according to Claim 2, wherein the switchable current source contains a current limiting resistor (16) and a switch (17), wherein a control electrode of the switch (17) forms the control electrode of the discharging unit (15).

4. Apparatus according to either of Claims 2 and 3, wherein the comparators (14) are designed to output the control signal with the first logic level if a cell voltage of the assigned battery cell (1) is greater than the minimum cell voltage of all the cell voltages of the battery cells (1) plus an offset voltage.

5. Apparatus according to any of the preceding claims, wherein the potential replication devices each comprise a pnp transistor (13) and an npn transistor (12), wherein a base of the pnp transistor (13) is connected to the first pole of the assigned battery cell (1), an emitter of the pnp transistor (13) is connected to a base of the npn transistor (12), and an emitter of the npn transistor (12) is connected to the first of the respective two adjacent resistors (3).

6. Apparatus according to any of the preceding claims, wherein the plurality of series-connected resistors (3) each have a resistance value corresponding to a quotient of the minimum cell voltage of all the cell voltages of the battery cells (1) and the current proportional to the minimum cell voltage of all the cell voltages of the battery cells (1).

7. Apparatus according to any of the preceding claims, wherein the measuring apparatus has a number n of differential amplifiers, wherein each of the differential amplifiers comprises a pair of transistors (2-1, 2-2), the emitter or source of which are connected to one another and to an input for a current source (10) and the control electrodes of which are connected to a respective one of two signal inputs of the differential amplifier.

8. Apparatus according to Claim 7, wherein the input for the current source (10) of a first one of the differential amplifiers is connected to a current source (10) and the collector or the drain of one of the transistors (2-2) of the pair of transistors (2-1, 2-2) is connected to the input for the current source (10) of a further one of the differential amplifiers, thus resulting in a cascading of the differential amplifiers.

9. Battery comprising a plurality of battery cells (1) connected in series and an apparatus according to any of the preceding claims, said apparatus being connected to the battery cells (1).

10. Motor vehicle comprising an electric drive motor for driving the motor vehicle and a battery according to the preceding claim, said battery being connected to the electric drive motor.

## Revendications

1. Dispositif d'équilibrage des cellules (1) d'une batterie présentant plusieurs cellules (1) de batterie raccordées en série, le dispositif comprenant
un dispositif de mesure relié à chacune des cellules (1) de batterie ou apte à leur être relié et configuré pour former un courant proportionnel à la tension minimale parmi toutes les tensions des cellules (1) de batterie et pour l'appliquer sur plusieurs résistances (3) raccordées en série,
un nombre n de résistances (3) étant égal au nombre de cellules (1) de batterie reliées ou aptes à être reliées au dispositif de mesure et à un nombre (n-1) de dispositifs (12, 13) de réplication de potentiel, tous raccordés entre deux résistances (3) voisines parmi les différentes résistances (3) et configurés pour répliquer un potentiel sur un premier pôle d'une cellule (1) de batterie associée et pour le délivrer à une première des deux résistances (3) voisines, **caractérisé par**
un nombre n de comparateurs (14) qui présentent chacun une première entrée raccordée à un deuxième pôle d'une cellule (1) de batterie associée, une deuxième entrée reliée à une deuxième des résistances (3) voisines et une sortie raccordée à une électrode de commande d'une unité de décharge (15) respective, et configurés pour comparer une première tension appliquée sur la première entrée à une deuxième tension appliquée sur la deuxième entrée et délivrer un signal de commande en fonction du résultat de la comparaison, les unités de décharge (15) étant raccordées en parallèle à une cellule (1) de batterie respective et configurée pour faire s'écouler un courant de décharge hors de la cellule (1) de batterie concernée en fonction du signal de commande.

2. Dispositif selon la revendication 1, dans lequel les unités de déchargement (15) contiennent une source de courant commutable configurée pour laisser s'écouler le courant de décharge à un premier niveau logique du signal de commande et interrompre l'écoulement du courant à un deuxième niveau logique du signal de commande.

3. Dispositif selon la revendication 2, dans lequel la source de courant commutable contient une résistance (16) de limitation du courant et un commutateur (17), une électrode de commande du commutateur (17) formant l'électrode de commande de l'unité de décharge (15).

4. Dispositif selon l'une des revendications 2 ou 3, dans lequel les comparateurs (14) sont configurés pour délivrer le signal de commande au premier niveau logique si une tension de la cellule (1) de batterie associée est supérieure à la tension minimale de toutes les tensions de cellules (1) de batterie par rapport à une tension de décalage.

5. Dispositif selon l'une des revendications précédentes, dans lequel les dispositifs de réplication de potentiel comportent chacun un transistor pnp (13) et un transistor npn (12), une base du transistor pnp (13) étant raccordée au premier pôle de la cellule (1) de batterie associée, un émetteur du transistor pnp (13) étant raccordé à une base du transistor npn (12) et un émetteur du transistor npn (12) étant raccordé à la première des deux résistances (3) voisines.

6. Dispositif selon l'une des revendications précédentes, dans lequel les différentes résistances (3) raccordées en série présentent chacune une valeur qui correspond au quotient de la tension minimale de toutes les tensions des cellules (1) de batterie par le courant proportionnel à la tension minimale de toutes les tensions des cellules (1) de batterie.

7. Dispositif selon l'une des revendications précédentes, dans lequel le dispositif de mesure présente plusieurs amplificateurs différentiels, chacun des amplificateurs différentiels comportant une paire de transistors (2-1, 2-2) dont l'émetteur ou la source sont raccordés l'un à l'autre et à une entrée d'une source de courant (10) et dont les électrodes de commande sont raccordées à une parmi deux entrées respectives de signaux de l'amplificateur différentiel.

8. Dispositif selon la revendication 7, dans lequel l'entrée pour la source de courant (10) d'un premier amplificateur différentiel est raccordée à une source de courant (10) et le collecteur ou le drain d'un des transistors (2-2) de la paire de transistors (2-1, 2-2) et raccordé à l'entrée pour la source de courant (10) d'un autre amplificateur différentiel de manière à obtenir une mise en cascade des amplificateurs différentiels.

9. Batterie dotée de plusieurs cellules (1) de batterie raccordées en série et d'un dispositif selon l'une des revendications précédentes raccordé aux cellules (1) de batterie.

10. Véhicule automobile doté d'un moteur électrique d'entraînement qui entraîne le véhicule automobile et d'une batterie selon la revendication précédente, raccordée au moteur électrique d'entraînement.
